# EUROPEAN PATENT APPLICATION

(11) **EP 4 776 800 A1**
(43) Date of publication of application: **15.07.2026**
(21) Application number: 25226935.2
(22) Date of filing: 23.12.2025
(51) Int. Cl.: H10H 20/85, H10H 20/853, H10H 20/856

(54) **HIGH-CONCENTRATION LED LIGHT SOURCE**

(30) Priority: 03.01.2025 US 202563741774 P; 28.10.2025 US 202519372057
(71) Applicant: Manlux Technologies, Inc., San Mateo, CA 94404 (US)
(72) Inventor: MAN, Kin Wah, London (GB); HOCK, Yeo Chun, Wanchai (HK); LIU, Jian Qiang, Shenzhen (CN)
(74) Representative: Müller-Boré & Partner Patentanwälte PartG mbB

(57) **Abstract**

A compact, high-concentration LED light source includes a reflective molded substrate. LED dies are mounted in a central recessed portion of the substrate. The substrate is molded to have an inner annular wall, with angled sides, and an outer annular wall that is also angled. A liquid fluorescent material is deposited within the inner angular wall to encapsulate the LED dies and cured. A silicone lens is then molded directly on the substrate to encapsulate the fluorescent material and the inner annular wall and abut the outer annular wall. A locking feature in the substrate, formed by a gap with a narrowed neck portion, secures the lens after curing to prevent delamination due to thermal cycling. The gap formed in the molded reflective substrate also forms reflective angled surfaces that direct the light out of the light source.

## Description

### CROSS REFERENCE TO RELATED APPLICATIONS

This application claims priority to US provisional application serial number 63/741,774, filed January 3, 2025, assigned to the present assignee and incorporated herein by reference.

### TECHNICAL FIELD

This invention relates to compact light emitting diode (LED) light sources, such as surface mountable light sources, and specifically, to a LED light source containing fluorescent material and light reflecting features integral with a mounting substrate.

### BACKGROUND

A conventional high-power LED light source that produces a concentrated beam of light includes an LED mounted in a reflective cup, where the cup is filled with a fluorescent material, such as YAG powder in a transparent medium. A separately molded lens is then adhesively secured over the LED die and fluorescent material. If the LED emits blue light and a YAG material is used, some of the blue light leaks through the YAG layer (emits yellow-green light) to cause the light source to emit white light.

Problems with such a light source include the delamination of the pre-molded lens, limitations on concentrating the beam due to light spreading, undesired internal reflections (which attenuate light), a relatively large size, and other issues.

What is needed is a compact LED light source containing a fluorescent material, where the light can be better concentrated for a brighter light, and where the lens is precisely positioned with no chance of delamination.

### SUMMARY

A high-concentration LED light source is disclosed where the mounting substrate is a single, reflective molded piece containing light reflection features, including an inner ring with an angled wall surrounding the LED die or dies. The inner ring reflects side light from the one or more LED dies and directs the light away from the substrate. The LED die is covered with a viscous fluorescent material, and the material is hardened. The inner ring restricts the flow of the fluorescent material, so helps define the shape of the fluorescent material. The fluorescent material forms a domed shape due to the surface tension of the liquid fluorescent material before curing. The domed shape of the fluorescent material improves color uniformity vs viewing angle. The fluorescent material is then covered with a transparent protective layer and hardened.

The molded reflective substrate has an angled outer ring that surrounds the inner ring. There is no fluorescent material between the inner annular ring and the angled outer ring.

A lens is molded directly over the substrate and LED die to fill the gap between the outer ring and inner ring. The lens helps concentrate the light by refraction. An anchoring feature in the substrate helps lock the molded lens in place, so there can be no delamination of the lens. The anchoring feature is achieved by a gap formed in the molded substrate that has a narrowed neck portion. The hardened transparent layer over the fluorescent material protects the fluorescent material from being deformed by the pressure of the liquid lens material when molding the lens directly over the substrate.

The gap formed in the molded reflective substrate also forms reflective angled surfaces that direct the light out of the light source.

The combination of the angled inner ring, the angled outer ring, the shaped fluorescent material, and the lens concentrates the light into a highly controlled beam shape. If the LED emits blue light and the fluorescent material contains a YAG powder, some blue light leaks through the fluorescent material (emits yellow-green light) to form a highly concentrated beam of white light.

### BRIEF DESCRIPTION OF THE DRAWINGS

FIG. 1 is a bisected front view of a high-concentration LED light source according to one embodiment of the present invention.
FIG. 2 illustrates the internal materials in the view of Fig. 1.
FIG. 3 is a bisected view illustrating a reflective molded substrate, with two LED dies mounted on metal bonding pads, where the substrate includes integral outer and inner angled rings.
FIG. 4 illustrates another embodiment of a reflective substrate having an inner ring and outer ring.
FIG. 5 illustrates cured fluorescent material over the LED dies (defined by the inner ring), where the fluorescent material has a raised ring, or other protrusions, on its top surface that further concentrates light, in accordance with another embodiment of the invention.
FIG. 6 illustrates a simple LED die having bottom bolding pads for soldering to bonding pads exposed in the mounting area of the substrate.
FIG. 7 is similar to Fig. 2 but adds a protective transparent layer over the fluorescent material to protect the fluorescent material from deforming when molding the lens directly over the substrate.

Elements that are the same or equivalent are labeled with the same numerals.

### DETAILED DESCRIPTION OF THE EMBODIMENTS

To make the purposes, technical solutions, and advantages of the present invention clearer, the following further describes the present invention in detail with reference to the accompanying drawings and embodiments. The specific embodiments described herein are used to explain the present invention but not to limit the present invention.

The same or similar reference numerals in the accompanying drawings of the embodiments correspond to the same or similar parts. In the description of the present invention, it should be understood that if the orientations or positional relationships indicated by the terms "upper", "lower", "left", "right", and the like are in accordance with those shown in the accompanying drawings, and are intended only for the convenience of describing the present invention and simplifying the description rather than for indicating or implying that the referred devices or elements must have a particular orientation or constructed or operated in a particular orientation; and therefore, the terms used to describe the positional relationships in the accompanying drawings are only for illustrative purposes and are not to be construed as limiting the present patent, and the specific meaning of the terms described above may be understood by those of ordinary skill in the art according to the specific circumstances.

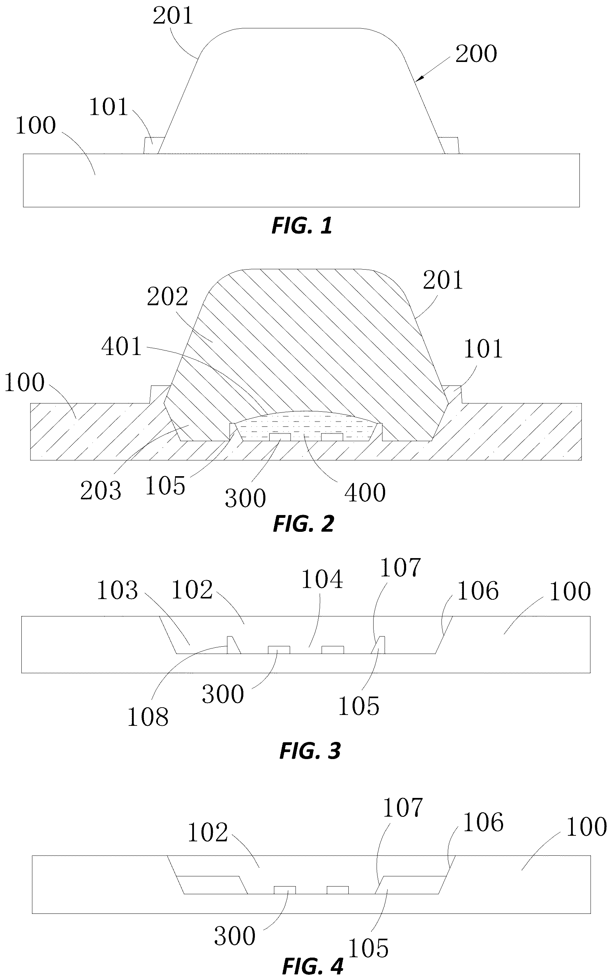

Figs. 1-7 show preferred embodiments of the present invention.

Fig. 1 illustrates a light source having a molded substrate 100. The substrate 100 may be a molded silicone that contains reflective materials. The silicone is a curable adhesive. In one embodiment, the substrate 100 comprises silicone infused with white particles, such as zinc oxide, so as to be reflective to visible light. The substrate 100 may also contain heat-conductive particles to conduct the LED heat to a metal circuit board.

The substrate 100 is molded over a copper lead frame (not shown) that provides top bonding pads for the LED dies and bottom bonding pads for attachment of the substrate 100 to a metal-core circuit board. Such a lead frame may be conventional.

Fig. 1 also shows the top edge of an outer dam 101, described later with respect to Fig. 2.

An encapsulating lens 200 is molded directly over the substrate 100 after the LED dies are bonded to the bonding pads. The lens surface 201 is shaped to refract light to direct the light output in the desired pattern, such as to narrow the beam. The steep angle of the lens 200 sides causes some total internal reflection that restricts side-light emission to concentrate the beam.

The lens 200 may have a circular top down footprint or may have a generally rectangular footprint, depending on the desired beam shape.

Figs. 2 and 3 show the inner structure of the light source of Fig. 1. The reflective substrate 100 is molded to include a recessed light emitting region 102 (Fig. 3). An array of LED dies 300 are mounted on bonding pads in a flat area 104 of the light emitting region 102. In one example, there are four LED dies. In another embodiment, there is only one LED die. The LED dies 300 may emit blue light or any other color. Blue light is suitable for a white light source.

The substrate 100 is molded to have an annular inner dam 105 with angled reflecting walls 107 (Fig. 3) that redirect side light from the LED dies 300 away from the substrate 100 and out through the lens 200. The inner part 202 of the lens 200 is solid and transparent.

The substrate 100 is also molded to include an annular outer dam 101 having angled walls 106 (Fig. 3) that redirect light away from the substrate 100. The inner dam 105 has vertical walls 108 (Fig. 3) that face the outer dam 101 to reflect light back at the outer dam 101. There is an annular region 103 (Fig. 3) between the inner dam 105 and the outer dam 101.

The substrate 100 is also molded to include a locking feature, formed by a gap between the inner dam 105 and the outer dam 101, that helps retain the lens 200 in place after the lens 200 is directly molded onto the substrate 100. The portion of the lens 200 in the locking feature is portion 203. The gap includes a narrowed neck portion, that receives the lower molded lens portion 203, that prevents delamination of the lens 200 due to repeated thermal cycling. Therefore, no additional adhesive is needed to secure the lens 200 to the substrate.

The angles of the locking feature also form reflective surfaces in the substrate 100 that reduce the emission angle and help concentrate the light.

After the LED dies 300 are bonded to the pads in the substrate 100, a liquid drop of a fluorescent material 400 (Fig. 2) is dispensed in the recessed light emitting region 102 and is retained within the inner dam 105. The fluorescent material 400 may be YAG powder infused in silicone. The YAG emits yellow-green light when energized by the blue LED light. Some of the blue light leaks through the fluorescent material 400 to create white light.

The domed shape of the fluorescent material 400 is due to surface tension after the liquid drop of the fluorescent material 400 is cured. The fluorescent material 400 encapsulates and protects the LED dies 300. Light emitted sideways from the LED dies 300 and light emitted sideways and downward from the fluorescent material 400 is reflected upward by the angled walls of the inner dam 105.

The cured structure is then mounted in a molding apparatus, and the silicone lens material is molded directly over the light emitting region 102, under pressure, to encapsulate the fluorescent material 400 and contact the top surface 401 (Fig. 2) of the fluorescent material 400. The substrate 100 features and the fluorescent material 400 effectively form part of the mold for the lens 200 so there is no air gap and there is a precise alignment with the substrate 100. The silicone is then cured by heat or UV light. Note in Fig. 2 how the lower molded lens portion 203 is locked within the annular feature of the outer dam 101 so that it is securely in place even without adhesion. This prevents delamination due to high thermal stresses.

Due to the shapes of the molded inner dam 105, outer dam 101, and the lens 200, the light from all sides of the LED dies 300 is reflected upward away from the reflective substrate 100. Light internally reflected within the lens 200 is ultimately reflected off the walls of the substrate 100 and escapes the lens 200. The various angled walls and the shape of the lens 200 results in a beam with a desired beam width and shape.

Since the lens 200 has good thermal contact with the LED dies 300, the lens 200 also removes heat from the LED dies 300.

Fig. 4 illustrates an alternative embodiment where the inner dam 105 forms a reflective ring that extends to the reflective outer angled wall 106. The inner dam 105 forms an angled inner reflective wall 107.

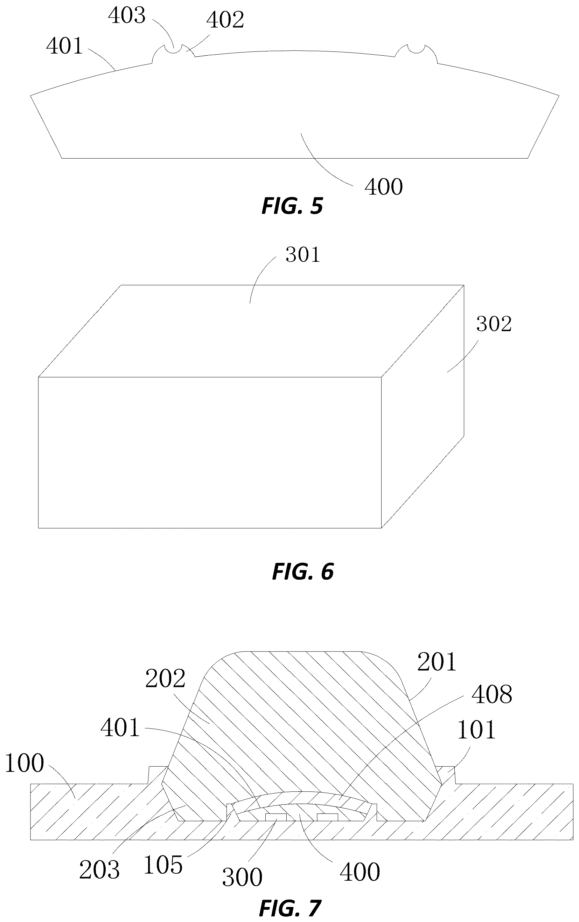

Fig. 5 illustrates an alternative embodiment of the fluorescent material 400 after it is dispensed over the LED dies and cured. After dispensing the fluorescent material 400, it is stamped with an annular pattern to form a raised ring 402 having a hemispherical groove 403. Such patterns can be used to change the emission pattern of the fluorescent material 400. Concentric rings 402 may also be used to shape the beam and improve light extraction. Other optical features may be molded or stamped into the fluorescent material 400 surface. The optical features help extract the light and shape the beam. The lens material then molds directly over the cured surface of the fluorescent material 400.

In another embodiment, the protruding portions of the fluorescent material 400 in Fig. 5 are hemispherical bumps arranged in a pattern on the surface of the fluorescent material to shape the light and improve light extraction (reduce total internal reflection).

Fig. 6 illustrates a conventional LED die having a top surface 301 and side surfaces 302. Two bonding pads (not shown) are provided on the bottom of the die. Both the top light and side light are redirected by the substrate features and the lens shape to achieve a wide range of possible beam shapes.

Fig. 7 illustrates another embodiment where a protective transparent window 408 is deposited over the fluorescent material 400 to protect the fluorescent material 400 from downward forces when molding the solid lens 200 directly over the fluorescent material 400. The window 408 may be a liquid that is dispensed, then cured.

The design of the compact light source provides a very rugged, high power light source that does not delaminate due to high thermal stresses. Since the lens 200 is formed of transparent silicone, the substrate 100 is formed of the same silicone containing reflective particles, and the fluorescent material 400 is formed of the same silicone containing fluorescent powder, the coefficients of thermal expansion of the lens, substrate, and fluorescent material are substantially the same, so there is little thermal stress and no delamination. Further, the indices of refraction of the three materials are very similar so there is less total internal refraction (TIR) at the interfaces of the materials.

No reflective metal is needed for the substrate since the substrate itself is reflective (e.g., white). The bonding pads for the LED dies may be reflective. The beam shape can be easily changed by modifying the substrate mold and lens mold.

In view of the foregoing, further aspects and embodiments of the present invention are described by the following items:
1. A light source comprising:
   a molded substrate formed of a reflective material, the substrate having a mounting area for at least one light emitting diode (LED) die,
   the substrate having an inner annular wall surrounding the mounting area, the inner annular wall having a first angled side configured to reflect side light from the at least one LED die,
   the substrate having an outer annular wall surrounding the inner annular wall, the outer annular wall having a second angled side;
   fluorescent material contained within the inner annular wall and covering the at least one LED die; and
   a lens molded directly over the substrate to encapsulate the fluorescent material and inner annular wall, the lens contacting the outer annular wall of the substrate.
2. The light source of item 1 wherein the substrate contains a gap forming a locking feature for the lens, wherein lens material fills the gap in the substrate.
3. The light source of item 1 further comprising a protective transparent layer over the fluorescent material.
4. The light source of item 1 wherein the fluorescent material has a domed shape.
5. The light source of item 1 wherein the inner annular wall has a second side, opposing the first angled side, wherein the second side faces the second angled side of the outer annular wall.
6. The light source of item 1 further comprising the at least one LED die mounted in the mounting area.
7. The light source of item 1 wherein the lens is formed of silicone and the substrate is also formed of silicone.
8. The light source of item 7 wherein the fluorescent material comprises silicone containing a fluorescent powder.
9. The light source of item 1 wherein the substrate contains reflective particles in a transparent medium.
10. The light source of item 1 wherein the inner angular wall, the outer angular wall, and the lens are formed to concentrate emitted light into a beam.
11. The light source of item 1 wherein the substrate contains a gap forming a locking feature for the lens, wherein lens material fills the gap in the substrate, the gap comprising:
   angled surfaces of the reflective substrate that direct light out of the light source.
12. The light source of item 1 wherein the gap includes a narrowed neck portion that locks in the lens to prevent the lens from delaminating.
13. A method of forming a light source comprising:
   molding a substrate, the substrate being a reflective material, the substrate having a mounting area for at least one light emitting diode (LED) die,
   the substrate having an inner annular wall surrounding the mounting area, the inner annular wall having a first angled side configured to reflect side light from the at least one LED die,
   the substrate having an outer annular wall surrounding the inner annular wall, the outer annular wall having a second angled side;
   dispensing a fluorescent material within the inner annular wall and covering the at least one LED die; and
   molding a lens directly over the substrate to encapsulate the fluorescent material and inner annular wall, the lens contacting the outer annular wall of the substrate.
14. The method of item 13 wherein molding the substrate comprises molding the substrate to contain a gap forming a locking feature for the lens, wherein liquid lens material fills the gap in the substrate.
15. The method of item 14 wherein the gap comprises angled surfaces of the reflective substrate that direct light out of the light source.
16. The method of item 14 wherein the gap includes a narrowed neck portion that locks in the lens to prevent the lens from delaminating.
17. The method of item 13 further comprising forming a protective transparent layer over the fluorescent material prior to molding the lens.

The foregoing descriptions are merely preferred embodiments of the present invention, but are not intended to limit the present invention. Any modification, equivalent replacement, or improvement made without departing from the spirit and principle of the present invention shall fall within the protection scope of the present invention.

## Claims

1. A light source comprising:
a molded substrate formed of a reflective material, the substrate having a mounting area for at least one light emitting diode (LED) die,
the substrate having an inner annular wall surrounding the mounting area, the inner annular wall having a first angled side configured to reflect side light from the at least one LED die,
the substrate having an outer annular wall surrounding the inner annular wall, the outer annular wall having a second angled side;
fluorescent material contained within the inner annular wall and covering the at least one LED die; and
a lens molded directly over the substrate to encapsulate the fluorescent material and inner annular wall, the lens contacting the outer annular wall of the substrate.

2. The light source of claim 1 wherein the substrate contains a gap forming a locking feature for the lens, wherein lens material fills the gap in the substrate.

3. The light source of claim 1 or 2 further comprising a protective transparent layer over the fluorescent material.

4. The light source of any one of the preceding claims wherein the inner annular wall has a second side, opposing the first angled side, wherein the second side faces the second angled side of the outer annular wall.

5. The light source of any one of the preceding claims further comprising the at least one LED die mounted in the mounting area.

6. The light source of any one of the preceding claims wherein the lens is formed of silicone and the substrate is also formed of silicone.

7. The light source of any one of the preceding claims wherein the substrate contains reflective particles in a transparent medium.

8. The light source of any one of the preceding claims wherein the inner angular wall, the outer angular wall, and the lens are formed to concentrate emitted light into a beam.

9. The light source of any one of the preceding claims wherein the substrate contains a gap forming a locking feature for the lens, wherein lens material fills the gap in the substrate, the gap comprising:
angled surfaces of the reflective substrate that direct light out of the light source.

10. The light source of any one of the preceding claims wherein the gap includes a narrowed neck portion that locks in the lens to prevent the lens from delaminating.

11. A method of forming a light source comprising:
molding a substrate, the substrate being a reflective material, the substrate having a mounting area for at least one light emitting diode (LED) die,
the substrate having an inner annular wall surrounding the mounting area, the inner annular wall having a first angled side configured to reflect side light from the at least one LED die,
the substrate having an outer annular wall surrounding the inner annular wall, the outer annular wall having a second angled side;
dispensing a fluorescent material within the inner annular wall and covering the at least one LED die; and
molding a lens directly over the substrate to encapsulate the fluorescent material and inner annular wall, the lens contacting the outer annular wall of the substrate.

12. The method of claim 11 wherein molding the substrate comprises molding the substrate to contain a gap forming a locking feature for the lens, wherein liquid lens material fills the gap in the substrate.

13. The method of claim 12 wherein the gap comprises angled surfaces of the reflective substrate that direct light out of the light source.

14. The method of claim 12 or 13 wherein the gap includes a narrowed neck portion that locks in the lens to prevent the lens from delaminating.

15. The method of any one of claims 11 to 14 further comprising forming a protective transparent layer over the fluorescent material prior to molding the lens.
